# EUROPÄISCHE PATENTSCHRIFT

(11) **EP 2 583 314 B1**
(45) Veröffentlichungstag und Bekanntmachung des Hinweises auf die Patenterteilung: **07.12.2016**
(21) Anmeldenummer: 11726706.2
(22) Anmeldetag: 16.06.2011
(51) Int. Cl.: H01L 31/18

(54) **VERFAHREN ZUR HERSTELLUNG EINER METALLISCHEN KONTAKTSTRUKTUR EINER PHOTOVOLTAISCHEN SOLARZELLE**
METHOD FOR PRODUCING A METAL CONTACT STRUCTURE OF A PHOTOVOLTAIC SOLAR CELL
PROCÉDÉ DE FABRICATION D'UNE STRUCTURE DE CONTACT MÉTALLIQUE D'UNE CELLULE SOLAIRE PHOTOVOLTAÏQUE

(30) Priorität: 10.05.2011 DE 102011101083; 18.06.2010 DE 102010024307
(43) Veröffentlichungstag der Anmeldung: 24.04.2013
(73) Patentinhaber: Fraunhofer-Gesellschaft zur Förderung der angewandten Forschung e.V., 80686 München (DE)
(72) Erfinder: BIRO, Daniel, 79106 Freiburg (DE); THAIDIGSMANN, Benjamin, 79104 Freiburg (DE); CLEMENT, Florian, 79102 Freiburg (DE); WOEHL, Robert, 79098 Freiburg (DE); WOTKE, Edgar-Allan, 10825 Berlin (DE)
(86) Internationale Anmeldenummer: PCT/EP2011/002963
(87) Internationale Veröffentlichungsnummer: WO 2011/157420

(56) Entgegenhaltungen:
- WO-A1-2009/059302
- WO-A1-2010/135535
- DE-A1-102009 009 840
- US-A- 4 703 553
- US-A1- 2010 098 840

## Beschreibung

Die Erfindung betrifft ein Verfahren zur Herstellung einer metallischen Kontaktstruktur einer photovoltaischen Solarzelle gemäß Oberbegriff des Anspruchs 1.

Eine photovoltaische Solarzelle stellt ein flächiges Halbleiterelement dar, bei dem mittels einfallender elektromagnetischer Strahlung eine Erzeugung von Elektron-Lochpaaren erzielt wird und an mindestens einem pn-Übergang eine Ladungsträgertrennung erfolgt, so dass zwischen mindestens zwei elektrischen Kontakten der Solarzelle eine elektrische Potentialdifferenz entsteht und über einen mit diesen Kontakten verbundenen externen Stromkreis elektrische Leistung von der Solarzelle abgegriffen werden kann.

Die Ladungsträger werden dabei über metallische Kontaktstrukturen eingesammelt, so dass durch Kontaktierung dieser Kontaktstrukturen an einem oder mehreren Kontaktpunkten die Ladungsträger in den externen Stromkreis eingespeist werden können.

US 2010/098840 A1 beschreibt ein Verfahren zur Herstellung einer rückseitenkontaktierten Solarzelle unter Verwendung zweier unterschiedlicher Pasten für die Kontaktierung.

DE 10 2009 009 840 A1 beschreibt ein Verfahren zur Herstellung einer metallischen Kontaktstruktur mit einem None-Impact-Druckverfahren.

WO 2009/059302 A1 beschreibt die Herstellung einer Solarzelle mit einer gedruckten metallischen Kontaktierungsstruktur, welche mittels Durchfeuern eine elektrische Kontaktierung erzielt.

WO 2010/135535 A1 beschreibt einen Herstellungsprozess eines Metallisierungsgitters auf der Vorderseite einer Siliziumsolarzelle.

US 4,703,553 beschreibt die Herstellung einer Metallisierungsstruktur einer photovoltaischen Solarzelle mittels Aufbringen von Druckpasten, wobei die Druckpaste nach dem Aufbringen getrocknet wird.

Hinsichtlich der Ausbildung der metallischen Kontaktstruktur stellen sich konkurrierende Anforderungen: Einerseits soll die mittlere Weglänge eines Ladungsträgers in dem Halbleitersubstrat zu dem nächstliegenden Kontaktpunkt mit einer metallischen Kontaktstruktur gering sein, um ohmsche Verluste aufgrund von Leitungswiderständen innerhalb des Halbleiters gering zu halten. Andererseits soll die Kontaktfläche zwischen metallischer Kontaktstruktur und Halbleitersubstrat gering sein, da an der Kontaktfläche eine hohe Rekombinationsrate, verglichen mit elektrisch passivierten Oberflächen des Halbleitersubstrates vorliegt.

Insbesondere bei Solarzellen, bei denen ein Emitter und somit auch der die erzeugten Ladungsträgerpaare trennende pn-Übergang an oder im Bereich der zum Lichteinfall ausgebildeten Vorderseite der Solarzelle ausgebildet ist, erfolgt typischerweise die elektrische Kontaktierung der Basis mittels einer rückseitig angeordneten metallischen Kontaktierungsschicht, welche elektrisch leitend mit dem Halbleitersubstrat verbunden ist. Hierbei ist zur Erzielung hoher Wirkungsgrade eine effiziente rückseitige Passivierung, d. h. die Erzielung einer geringen Oberflächenrekombinationsgeschwindigkeit für Minoritätsladungsträger, insbesondere im Bereich der rückseitigen Oberfläche des Halbleitersubstrates sowie eine Ausbildung des elektrischen Kontaktes mit niedrigem Kontaktwiderstand wesentlich.

So sind Solarzellenstrukturen bekannt, bei denen die Rückseite des Halbleitersubstrates im wesentlichen ganzflächig mit einer als Siliziumnitridschicht, Siliziumdioxidschicht oder Aluminiumoxidschicht oder Schichsystemen ausgebildeten Passivierungsschicht oder Isolierungsschicht bedeckt ist, so dass niedrige Oberflächenrekombinationsgeschwindigkeiten erzielt werden. Lediglich an Punktkontakten ist die passivierende Schicht punktartig oder kleinflächig linenförmig geöffnet und es besteht eine elektrisch leitende Verbindung zu einer metallischen Kontaktierungsschicht, welche auf der Passivierungsschicht angeordnet ist. Hierbei ist die Gesamtfläche der verteilten Kontakte deutlich geringer als die Fläche der Rückseite der Solarzelle. Eine solche Solarzellenstruktur ist beispielsweise die PERL-Struktur (passivated emitter, rear locally defused) wie in J. Benick, B. Hoex, G. Dingemans, A. Richter, M. Hermle, and S. W. Glunz "High-efficiency n-type silicon solar cells with front side boron emitter," in Proceedings of the 24th European Photovoltaic Solar Energy Conference (Hamburg, Germany), 2009 und in Zhao et al., Proc. of the 21st IEEE PVSC, 333 (1990) beschrieben. Diese Struktur, welche rückseitige Kontaktierung zur Erreichung hoher Wirkungsgrade ermöglicht, erfordert bei der Herstellung zusätzliche Photolithografieschritte, so dass eine industrielle Implementierung dieser Solarzellenstruktur nicht praktikabel oder zumindest sehr kostenintensiv ist.

Der vorliegenden Erfindung liegt daher die Aufgabe zugrunde, ein Verfahren zur Herstellung einer metallischen Kontaktstruktur einer photovoltaischen Solarzelle zu schaffen, welches industriell kostengünstig implementierbar ist und gleichzeitig hohe Wirkungsgrade durch die Kombination großflächig passivierter Bereiche mit lokalen Kontaktierungsbereichen zu einer metallischen Kontaktstruktur ermöglicht.

Gelöst ist diese Aufgabe durch ein Verfahren gemäß Anspruch 1. Vorteilhafte Ausgestaltungen des erfindungsgemäßen Verfahrens finden sich in den Ansprüchen 2 bis 14.

Das erfindungsgemäße Verfahren zur Herstellung einer metallischen Kontaktstruktur einer photovoltaischen Solarzelle umfasst folgende Verfahrensschritte:
In einem Verfahrensschritt A wird eine elektrisch nicht leitende Isolierungsschicht auf eine Oberfläche eines Halbleitersubstrates, gegebenenfalls auf eine oder mehrere diese Oberfläche bedeckende Zwischenschichten aufgebracht.

In einem Verfahrensschritt B wird eine metallische Kontaktschicht auf die Isolierungsschicht, gegebenenfalls auf eine oder mehrere die Isolierungsschicht bedeckende Zwischenschichten aufgebracht. Weiterhin werden eine oder mehrere lokale elektrisch leitende Verbindungen zwischen Halbleitersubstrat und Kontaktschicht durch die Isolierungsschicht und gegebenenfalls weitere zwischen Kontaktschicht und Halbleitersubstrat liegende Zwischenschichten hindurch erzeugt.

Ergebnis der Verfahrensschritte A und B ist somit, dass die Oberfläche des Halbleitersubstrates weitgehend durch die Isolierungsschicht einerseits gegenüber der metallischen Kontaktschicht elektrisch isoliert ist und andererseits hinsichtlich der Rekombinationsaktivitäten passiviert ist und lediglich an mehreren lokalen Bereichen eine elektrisch leitende Verbindung zwischen Halbleitersubstrat und Kontaktschicht durch die Isolierungsschicht hindurch besteht.

Wesentlich ist, dass in Verfahrensschritt B die metallische Kontaktschicht folgende Verfahrensschritte umfassend ausgebildet wird:
In einem Verfahrensschritt B1 wird eine erste Metallpartikel enthaltende Paste an mehreren lokalen Bereichen aufgebracht. Dies sind diejenigen lokalen Bereiche, an denen eine elektrisch leitende Verbindung zu dem Halbleitersubstrat erzeugt werden soll.

In einem Verfahrensschritt B2 wird eine zweite Metallpartikel enthaltende Paste flächig, zumindest die mit der ersten Paste bedeckten Bereiche sowie die dazwischen liegenden Bereiche zumindest teilweise bedeckend aufgebracht. Die mittels der zweiten Paste ausgebildete Schicht überdeckt somit zumindest die in Verfahrensschritt B1 aufgebrachten Bereiche der ersten Paste sowie zumindest teilweise die dazwischen liegenden Bereiche.

In einem Verfahrensschritt B3 erfolgt ein globales Erhitzen des Halbleitersubstrates in einem Temperaturschritt.

Die erste und zweite Paste sowie der oder die auf Verfahrensschritt B1 folgende Temperaturschritt sind dabei derart ausgebildet, dass die erste Paste die Isolierungsschicht durchdringt und einen elektrisch leitenden Kontakt unmittelbar mit dem Halbleitersubstrat bildet, wohingegen die zweite Paste die Isolierungsschicht nicht durchdringt. Die sich aus der zweiten Paste ausbildende Metallschicht ist somit lediglich mittelbar über die erste Paste bzw. der sich hieraus bildenden Metallstrukturen mit dem Halbleitersubstrat elektrisch leitend verbunden.

Mit dem erfindungsgemäßen Verfahren ist es somit erstmals möglich, in einfacher, industriell kostengünstig implementierbarer Weise eine elektrische Kontaktierung der Rückseite einer Solarzelle zu erzielen, welche einerseits großflächig passivierte Bereiche und andererseits lokale Kontaktierungsbereiche aufweist. Durch die Verwendung zweier verschiedener Pasten, von denen lediglich die erste in dem oder den auf die Pastenaufbringung folgenden Temperaturschritten die Isolierungsschicht durchdringt, kann mit kostengünstigen Methoden die zuvor genannte vorteilhafte Kontaktierungsstruktur mit mehreren lokalen Kontaktierungsbereichen und großflächig passivierten Bereichen auf der Oberfläche des Halbleitersubstrates erzielt werden.

Insbesondere kann zur Aufbringung der Pasten auf an sich bekannte, bereits industriell implementierte Methoden wie beispielsweise Siebdruck oder Inkjet-Druckverfahren zurückgegriffen werden, die bereits für hohe Durchsatzraten im Inline-Verfahren und damit kostengünstige Herstellungsprozesse etabliert sind.

Zur Aufbringung der Pasten können verschiedene Verfahren eingesetzt werden: Siebdruck, Schablonendruck, Dispensen, Inkjetten, Lasertransferdrucken, Tampondrucken, Tiefdruck und andere Druck- und Depositionsverfahren. Vorzugsweise wird an das Aufbringen der Pasten ein Trocknungsschritt angeschlossen werden, um die Pasten zu verfestigen.

Weiterhin kann zur Erzeugung der metallischen Kontaktstruktur mittels des erfindungsgemäßen Verfahrens gänzlich auf kostenintensive Fotolithografie verzichtet werden. Lediglich die erste Paste muss gezielt in den für die lokale Kontaktierung vorgesehenen Bereichen aufgebracht werden. Dies ist jedoch beispielsweise mit den vorgenannten bereits bekannten Verfahren, insbesondere Siebdruck-, Schablonendruck oder Inkjet-Druckverfahren oder Dispensen bereits heute problemlos möglich. Die Isolierungsschicht und die zweite Paste können großflächig und insbesondere ganzflächig aufgetragen werden, so dass auch hier keinerlei Maskierungsschritte notwendig sind.

Mit dem erfindungsgemäßen Verfahren wird somit die bisher in kostenintensiven komplexen Prozessen realisierte Kontaktierungsstruktur zur Herstellung hocheffizienter Solarzellen in ein kostengünstiges industrielles Herstellungsverfahren implementierbar.

Das globale Erhitzen in Verfahrensschritt B3 erfolgt vorzugsweise in einem Fast Firing Ofen als Feuerungsschritt, bei dem die Wafer in einem Durchlaufverfahren durch den heißen Bereich des Ofens gefördert werden. Hierbei werden vorzugsweise Temperaturen von bis zu 1000°C erreicht wobei vorzugsweise Maximaltemperaturen kleiner 900°C verwendet werden. Der Feuerungsprozess wird vorzugsweise sehr kurz ausgeführt werden, so dass die Wafer nur wenige Minuten in dem Ofen verweilen und nur wenige Sekunden auf die Temperatur aufgeheizt werden, wodurch sich dieser Prozess von reinen Trockungsprozessen deutlich unterscheidet.

Vorzugsweise wird die zweite Metallpartikel enthaltende Paste derart flächig zwischen die mit der ersten Paste bedeckten Bereiche aufgebracht, dass die zweite Paste die mit der ersten Paste bedeckten Bereiche verbindet, derart, dass nach Verfahrensschritt B3 eine elektrisch leitende Verbindung zwischen den aus der ersten Paste resultierenden Strukturen durch die aus der zweiten Paste resultierende Struktur besteht. Hierbei werden bevorzugt zumindest zwei benachbarte aus der ersten Paste resultierende Strukturen durch die aus der zweiten Paste resultierende Struktur elektrisch leitend verbunden. Weiter bevorzugt, ist jede aus der ersten Paste resultierende Struktur mittels einer aus der zweiten Paste resultierenden Struktur elektrisch leitend mit mindestens einer weiteren aus der ersten Paste resultierenden Struktur verbunden.

Vorteilhafterweise wird die zweite Metallpartikel enthaltende Paste derart flächig aufgebracht, dass mindestens 30 %, bevorzugt mindestens 50 % der Fläche der Zwischenbereiche, welche Zwischenbereiche zwischen den mit der ersten Paste bedeckten Bereiche liegen, durch die zweite Paste bedeckt ist.

Vorzugsweise wird die zweite Paste in Verfahrensschritt B2 derart aufgebracht, dass sie die mit der ersten Paste bedeckten Bereiche sowie die dazwischen liegenden Bereiche vollständig überdeckt. Hierdurch ist insbesondere ein geringer elektrischer Querleitungswiderstand gewährleistet. Ebenso liegt es im Rahmen der Erfindung, dass die dazwischen liegenden Bereiche lediglich teilweise, beispielsweise linienartig mit der zweiten Paste bedeckt werden. Hierdurch ist eine elektrisch leitende Verbindung durch die zweite Paste, bzw. die hieraus entstehende Metallstruktur gewährleistet, wobei aufgrund der teilweisen Bedeckung Paste eingespart wird, gegenüber der vollflächigen Bedeckung der dazwischen liegenden Bereiche. Ebenso liegt es im Rahmen der Erfindung diese Kontaktierungsstruktur für die Ausbildung von rückseitenkontaktierten Solarzellen wie MWT-, EWT- oder Back Junction Solarzellen einzusetzen.

Zur Verschaltung einer Solarzelle mit einem externen Stromkreis bzw. weiteren Solarzellen bei Modulverschaltung werden typischerweise metallische Kontaktstrukturen der Solarzelle mittels eines Lötverfahrens mit einem metallischen Zellverbinder verlötet. Typischerweise eignen sich die metallischen Kontaktstrukturen aufgrund ihrer Zusammensetzung jedoch nicht oder nur bedingt für eine Lötverbindung, weshalb üblicherweise so genannte "Lötpads", d. h. lokale metallische Kontaktstrukturen, welche einerseits eine elektrisch leitende Verbindung mit der metallischen Kontaktierungsstruktur der Solarzelle ausbilden und andererseits gute lötbare Eigenschaften aufweisen, zusätzlich auf die Solarzelle aufgebracht.

Bei dem erfindungsgemäßen Verfahrens umfasst Verfahrensschritt B daher zusätzlich einen Verfahrensschritt Ba, wobei in Verfahrensschritt Ba auf mindestens einen lokalen Teilbereich eine dritte Metallpartikel enthaltende Paste aufgebracht wird, welche derart ausgebildet ist, dass die dritte Paste nach Wärmeeinwirkung lötbare metallische Strukturen bildet. Auf diese Weise wird in kostengünstiger und insbesondere im Inline-Verfahren implementierbarer Verfahrensweise zusätzlich ein Lötpad ausgebildet.

Besonders vorteilhaft wird die dritte Paste noch vor der zweiten Paste auf dem Substrat angeordnet, so dass die zweite Paste bereichsweise die dritte Paste überlappen kann, damit eine besonders gute elektrische und mechanische Verbindung dieser beiden Pasten im anschließenden Feuerungsschritt ausgebildet wird.

In einer besonders einfachen Ausführung sind die dritte Paste und die erste Paste identisch und werden in einem Schritt angeordnet beispielsweise durch einen Siebdruckprozess. Die zweite Paste wird dann derart angeordnet, dass die zuvor erzeugten Lötpads nicht oder nur bereichsweise bedeckt sind und so für eine spätere Kontaktierung der Solarzelle beispielsweise durch Löten oder Kleben zugänglich sind.

Die dritte Paste wird vorzugsweise derart aufgebracht, dass die daraus resultierende metallische Struktur mit der aus der zweiten Paste resultierenden metallischen Struktur und/oder der aus der ersten Paste metallischen resultierenden Struktur elektrisch leitend verbunden ist.

Vorzugsweise sind die dritte Paste sowie der oder die auf Verfahrensschritt B1 folgenden Temperaturschritte derart ausgebildet, dass die dritte Paste die Isolierungsschicht nicht durchdringt. In dieser vorzugsweisen Ausführungsform des erfindungsgemäßen Verfahrens wird weiterhin in Verfahrensschritt B1 die erste Paste auf mindestens eine erste Gruppe und eine zweite Gruppe lokaler Bereiche aufgebracht, wobei in Verfahrensschritt B2 die zweite Paste die mit der ersten Paste bedeckten Bereiche der ersten Gruppe sowie die dazwischen liegenden Bereiche bedeckend aufgebracht wird und in Verfahrenschritt Ba die dritte Paste die mit der ersten Paste bedeckten Bereiche der zweiten Gruppe sowie die dazwischen liegenden Bereiche bedeckend aufgebracht wird.

In dieser vorteilhaften Ausführungsform erfolgt das Durchdringen der Isolierungsschicht somit ausschließlich durch die erste Paste bzw. die hieraus resultierenden metallischen Strukturen. Die aus der dritten Paste resultierende metallische Struktur ist einerseits über die mit der erste Paste bedeckten lokalen Bereiche der zweiten Gruppe direkt mit dem Halbleitersubstrat elektrisch leitend verbunden und darüber hinaus ist sie mit der zweiten Paste bzw. der hieraus resultierenden metallischen Struktur elektrisch leitend verbunden.

In einer alternativen vorteilhaften Ausführungsform ist die dritte Paste derart ausgebildet, dass sie in dem oder den auf Verfahrenschritt B1 folgenden Temperaturschritten die Isolierungsschicht durchdringt. In dieser Ausführungsform erfolgt somit unmittelbar ein elektrischer Kontakt zwischen der aus der dritten Paste resultierenden metallischen Kontaktstruktur und dem Halbleitersubstrat, wobei auch in dieser Ausführungsform die aus der dritten Paste resultierende Metallstruktur mit der aus der zweiten Paste resultierenden Metallstruktur elektrisch leitend verbunden ist. Insbesondere ist es hierbei vorteilhaft, dass die erste und die dritte Paste identisch sind und vorzugsweise in einem gemeinsamen Prozessschritt bevorzugt gleichzeitig auf das Halbleitersubstrat aufgebracht werden.

Vorzugsweise werden die zweite und die dritte Paste elektrisch leitend miteinander verbunden aufgebracht. Hierbei liegt es im Rahmen der erfindung, die zweite und die dritte Paste nicht überlappend, jedoch direkt aneinander angrenzend aufzubringen. Hierdurch ergibt sich der Vorteil, dass einerseits definierte Bereiche hinsichtlich der Lötpads an der Kontaktierungsseite der Solarzelle bei geringen Höhenunterschieden ausgebildet werden und andererseits durch das Aneinandergrenzen eine mit geringen ohmschen Leitungsverlusten behaftete elektrische leitende Verbindung zwischen zweiter und dritter Paste bzw. der hieraus resultierenden Metallstrukturen gewährleistet ist.

Um eine sichere elektisch leitende Verbindung zwischen erster und dritter Paste bzw. den hieraus resultierenden Strukturen zu gewährleisten ist es vorteilhaft, die zweite und die dritte Paste überlappend aufzubringen, vorzugsweise derart, dass die dritte Paste die zweite Paste überlappt. Vorzugsweise werden die Pasten derart überlappend aufgebracht, dass sie um eine Länge im Bereich zwischen 0,1 mm bis 2 mm überlappen.

In einer weiteren vorzugsweisen Ausführungsform des erfindungsgemäßen Verfahrens wird die dritte Paste auf die zweite Paste aufgebracht. Hierdurch entstehen zwar Höhenunterschiede an der Kontaktierungsseite, dafür kann die Genauigkeit der Druckverfahren mit einer höheren Toleranz versehen werden, da die Bereiche, welche mit zweiter und dritter Paste bedruckt werden, nicht mehr aneinandergrenzen.

In einer weiteren vorteilhaften Ausführungsform ist die zweite Paste derart ausgebildet, dass sie die Isolierungsschicht nicht durchdringt und dass sie nach Wärmeeinwirkung oder durch eine weitere Nachbehandlung eine lötbare oder auf andere Weise elektrisch verschaltbare metallische Struktur bildet oder solch eine Struktur auf ihr ausgebildet wird. Hierdurch wird die separate Erzeugung von Lötpads eingespart. In dieser vorzugsweisen Ausführungsform eignet sich somit die gesamte flächig aufgebrachte zweite Paste, bzw. die hieraus resultierende Metallstruktur für eine lötbare Verbindung oder eine alternative Verschaltungstechnologie. Insbesondere ist die zweite Paste, bzw. die hieraus resultierende Metallstruktur für eine elektrische Kontaktierung mittels Leitklebern geeignet, wie in "Fast and easy single step module assembly for back-contacted C-Si solar cells with conductive adhesives", 2003, Bultman, Osaka beschrieben.

Zur Ausführung des erfindungsgemäßen Verfahrens sind die dem Fachmann aus vorbekannten Siebdruck- oder Inkjet-Druckverfahren oder anderen Verfahrens zur Herstellung metallischer Kontaktstrukturen bekannten Metallpartikel enthaltenden Pasten verwendbar. Insbesondere ist dem Fachmann bekannt, welche Pasten für eine vorgegebene Isolierungsschicht bei vorgegebenen Temperaturschritten eine Durchdringung der Isolierungsschicht erzielen und welche nicht.

Die Isolierungsschicht ist vorzugsweise als dielektrische Schicht ausgebildet, insbesondere vorzugsweise als Siliziumnitridschicht, Siliziumoxidschicht, Aluminiumoxidschicht, Siliciumcarbidschicht, Titandioxidschicht oder Mischungen der genannten Materialien. Ebenso liegt die Ausbildung der Isolierungsschicht als Schichtsystem aus mehreren Schichten im Rahmen der Erfindung. Vorteilhafterweise weist die Isolierungsschicht bzw. das als Isolierungsschicht verwendete Schichtsystem eine Dicke im Bereich zwischen 5 nm und 500 nm, insbesondere zwischen 20 nm und 250 nm, im weiteren vorzugsweise zwischen 50 nm und 250 nm auf. Insbesondere hat sich ein Schichtsystem aus einer Schicht Aluminiumoxid und einer Schicht Siliziumnitrid vorzugsweise mit einer Gesamtdicke von 100 nm oder ein Schichtsystem aus einer Schicht Siliziumoxid und einer Schicht Siliziumnitrid, vorzugsweise mit einer Gesamtdicke von 200 nm in Versuchen des Anmelders als vorteilhaft, insbesondere hinsichtlich der Isolierungswirkung erwiesen.

Vorzugsweise weisen die erste und die zweite Paste folgende Spezifikation auf: Die erste Paste enthält vorzugsweise Stoffe, die die Isolierungsschicht bei einem Hochtemperaturschritt durchdringen. Insbesondere enthält die erste Paste vorzugsweise Glasfritte, bevorzugt bis zu 10 % Blei- und/oder Bismutborglas, oder reine Blei- bzw. Bismutoxide. In einer weiteren vorzugsweisen Ausführungsform enthält die erste Paste eines oder mehrere Oxide, bevorzugt aus der Gruppe: GeO2, P2O5, Na2O, K2O, CaO, Al2O3, MgO, TiO2, ZnO und B2O3. Um die Ausbildung eines besseren lokalen Back-Surface-Fields zu unterstützen, ist die Verwendung einer ersten Paste vorteilhaft, die mit Phosphor oder anderen Elementen, die dem Basisdotierungstyp entsprechen, angereichert ist. Ist die Basisdotierung eine p-Typ Dotierung, sind in der ersten Paste entsprechende Dotierstoffe enthalten, die eine p-Typ Dotierung erlauben. Insbesondere können enthalten sein Aluminium, Bor und/oder Gallium.

Die zweite Paste enthält vorzugsweise vorgenannte Stoffe, die die Passivierungsschicht angreifen, nicht oder nur in geringen Mengen (bevorzugt weniger als 2 %). Insbesondere enthält die zweite Paste vorzugsweise keine Glasfritte oder lediglich Glasfritte mit einem Anteil geringer als 1 %. Insbesondere wird vorzugsweise als zweite Paste eine Aluminiumpaste oder eine Kupferpaste verwendet. Die Aluminiumpaste zeichnet sich durch einen großen Anteil an aluminiumhaltigen Metallpartikeln aus (vorzugsweise größer 50%).

Die dritte Paste weist vorzugsweise folgende Spezifikationen auf: Vorzugsweise weist die dritte Paste einen Silberanteil von mindestens 70 % auf, um eine gute Lötbarkeit zu gewährleisten. Ebenso liegt die Verwendung einer dritten Paste, die mit anderen lötbaren Metallen angereichert ist, im Rahmen der Erfindung, vorzugsweise Zinn, Gold, Kupfer, Eisen oder Nickel oder Kombinationen hiervon. Der Gesamtanteil der lötbaren Metalle in der dritten Paste liegt vorzugsweise bei mindestens 70%.

Vorteilhafterweise wird eine dritte Paste verwendet, die zusätzlich Zusatzstoffe wie zur ersten Pasten genannt, aufweist, sofern ein Durchdringen der Isolierungsschicht durch die dritte Paste erfolgen soll. Insbesondere sind ist hierbei die Verwendung einer dritten Paste vorteilhaft, die zusätzlich Zusätze zur lokalen Hochdotierung aufweist die dem Basisdotierungstyp entsprechen, im Falle einer n-Dotierung bevorzugt Phosphor oder andere Elemente, im Falle einer p-Typ Basisdotierung bevorzugt Aluminium oder Bor oder andere Elemente.

In einer weiteren vorzugsweisen Ausführungsform wird nach Verfahrensschritt B1 und vor Verfahrensschritt B2 die erste Paste getrocknet. Der Trocknungsprozess umfasst vorzugsweise folgende Verfahrenschritte: Aufheizen auf eine Temperatur, bei der die eingesetzten Pastenträgermaterialien zumindest teilweise, vorzugsweise vollständig verdampfen. Vorzugsweise erfolgt im Trocknungsprozess ein Aufheizen auf eine Temperatur im Temperaturbereich zwischen 150 °C und 300 °C.

Die separate Trocknung der ersten Paste vor Aufbringung der zweiten Paste weist den Vorteil auf, dass die erste Paste trocken ist und damit ihre Form beim Aufbringen der zweiten Paste behält. Außerdem erfolgt keine Durchmischung der Pastenbestandteile, was verhindert, dass die durchfeuernde Wirkung abgeschwächt wird.

In einer weiteren vorzugsweisen Ausführungsform des erfindungsgemäßen Verfahrens erfolgt zwischen Verfahrensschritt B1 und Verfahrensschritt B2 kein Hochtemperaturschritt, d.h. insbesondere keine Erwärmung auf mehr als 500 °C.

Insbesondere ist es vorteilhaft, die erste und zweite Paste und besonders bevorzugt auch die dritte Paste in einem gemeinsamen Temperaturschritt zu behandeln, so dass in dem gemeinsamen Temperaturschritt in Verfahrensschritt B3 die Umwandlung sämtlicher aufgebrachter Pasten in metallische Kontaktstrukturen erfolgt. Hierdurch wird eine besonders einfache und kostengünstige Prozessierung ermöglicht.

Vorzugsweise ist mindestens eine der Pasten, vorzugsweise die Paste, die die Isolationsschicht durchdringt, mit Silizium oder einer Siliziumverbindung, vorzugsweise mit Silizium angereichert. Es liegt im Rahmen der Erfindung, dass die Anreicherung in einer Konzentration zwischen 0,1 % und 12 %, insbesondere in einer Konzentration zwischen 4 % und 8 % besteht. Die Anreicherung besteht jedoch bevorzugt in einer Konzentration zwischen 0,1 % und 99 %, des Weiteren bevorzugt in einer Konzentration zwischen 8 % und 80 %, insbesondere bevorzugt in einer Konzentration von 12 % bis 60 %.

Die Anreicherung mit Silizium oder einer Siliziumverbindung weist den Vorteil auf, dass der Legierungsvorgang zwischen dem in der Paste enthaltenen Metall und dem Silizium-Halbleitersubstrat, welcher unter anderem für die elektrische Leitfähigkeit entscheidend ist, wesentlich schädigungsärmer verläuft und somit die Rekombination nahe des Kontaktpunktes reduziert wird.

Ebenfalls liegt es im Rahmen der Erfindung Aluminiumsiliziumlegierungen der Paste beizumengen. Hierbei wird vorteilhafterweise eine Paste verwendet, welche eine Konzentration von Aluminiumsiliziumlegierung von mindestens 1 %, bevorzugt mindestens 10 %, weiter bevorzugt mindestens 25 % aufweist. Hierbei ist es insbesondere vorteilhaft, dass die Paste einen Siliziumanteil im Bereich von 5 % bis 90 %, vorzugsweise im Bereich von 12 % bis 80 % aufweist. Insbesondere ist es vorteilhaft, eine eutektische Mischung mit einem Anteil von etwa 12 % Silizium zu verwenden.

Eine Beimischung von Aluminium-Siliziumlegierungen hat den Vorteil, dass sich die Schmelztemperatur der Paste verringert und der Legierungsprozess homogener abläuft.

In einer weiteren vorzugsweisen Ausführungsform enthält die zweite Paste und/oder die dritte Paste Silber, vorzugsweise in einer Konzentration von mindestens 70%, insbesondere im Bereich von 80% bis 100%. Hierdurch ist eine Lötbarkeit der mittels der zweiten und/oder der dritten Pasten erzeugten Metallstruktur gewährleistet.

In einer weiteren vorzugsweisen Ausführungsform enthält die erste und/oder dritte Paste einen Dotierstoff des Basisdotierungstyps der herzustellenden Solarzelle. Hierdurch wird eine lokale Hochdotierung in den Bereichen erzielt, in denen die erste Paste bzw. die hieraus resultierende Metallstruktur unmittelbar in elektrischem Kontakt mit der Halbleiterstruktur steht. Durch solch eine lokale Hochdotierung aufgrund des Dotierstoffes der ersten Paste wird einerseits der Kontaktwiderstand und andererseits die Rekombinationsgeschwindigkeit jeweils an der Kontaktfläche Metall/Halbleiteroberfläche reduziert und somit eine weitere Wirkungsgradsteigerung der Solarzelle erzielt.

Weiterhin vorteilhaft ist die Verwendung einer aluminiumhaltigen Paste als erste Paste, vorzugsweise mit einem Aluminiumgehalt von 70% bis 100%. Hierdurch kann auf Halbleitersubstrat mit n-typ-Dotierung während des Hochtemperaturschritts ein rückseitiger p+-Emitter ausgebildet werden. Auf p-typ-Halbleitern kann eine lokale Hochdotierung und damit ein p+-Back-Surface-Field erzeugt werden, das die Rekombinationsrate verringert.

In einer weiteren vorzugsweisen Ausführungsform kann eine mit Silizium angereicherte Al-Paste als erste Paste für Zellkonzepte verwendet werden, bei denen auf der Rückseite zumindest teilweise ein p-typ-Emitter benötigt wird. Dieser entsteht bei dem Hochtemperaturprozess an den Stellen der Rückseite, die mit der aluminiumhaltigen Paste bedeckt sind. Das Aufbringen der Al-Paste kann dabei sowohl ganzflächig als auch strukturiert geschehen.

In einer vorzugsweisen Ausführungsform enthält daher mindestens die erste und/oder dritte Paste einen Dotierstoff des Emitterdotierungstyps, d.h. mit einem dem Basisdotierungstyp der herzustellenden Solarzelle entgegengesetzten Dotierungstyp. Hierdurch wird ein lokaler Emitter auf der Rückseite ausgebildet.

Vorzugsweise erfolgt in Verfahrenschritt B3 eine globale Erwärmung der Halbleiterstruktur auf mindestens 700°C für eine Zeitdauer von mindestens 5 s. Vorzugsweise wird während der genannten Zeitdauer ein Temperaturmaximum von mindestens 730°C erreicht.

Eine besonders kostengünstige industriell implementierbare Ausgestaltung des erfindungsgemäßen Verfahrens ergibt sich dadurch, dass mindestens eine der Pasten, vorzugsweise alle Pasten mittels Inkjet-Druckverfahren oder Arosoldruckverfahren aufgebracht werden. Das Aufbringen von Metallpartikel enthaltenden Pasten mittels Inkjet-Druckverfahren ist an sich bekannt und beispielsweise in "Spray and inkjet printing of hybrid nanoparticle-metal-organic inks for Ag and Cu metallizations", Curtis, 2002, Mat. Res. Soc. Symp. Proc. beschrieben.

Das erfindungsgemäße Verfahren findet vorzugsweise Anwendung zur Herstellung einer Solarzelle, die wesentlich durch ein Silizium-Halbleitersubstrat gebildet wird. Insbesondere ist das erfindungsgemäße Verfahren zur Ausbildung der Kontaktstruktur an der dem Lichteinfall gegenüberliegenden Rückseite der Solarzelle vorteilhaft.

Im Falle, dass die Basisdotierung und die durch die erste Paste erreichte Dotierung den gleichen Dotiertyp (beispielsweise p-Typ) aufweisen, ist es vorteilhaft, wenn der Bedeckungsanteil der Solarzellenseite durch die erste Paste, bzw. die hieraus hervorgehende Struktur kleiner ist als 50%, besonders vorteilhaft kleiner ist als 12% und bevorzugt kleiner ist als 7%. Ebenfalls ist in diesem Falle vorteilhaft, wenn mindestens eine Abmessung von Teilbereichen ersten Kontaktstrukturen kleiner ist als 500 µm, bevorzugt kleiner 200µm, im Weiteren kleiner 100µm insbesondere kleiner 50 µm. Diese Teilbereiche werden bevorzugt punktförmig oder linenartig ausgebildet, wobei mindestens eine Abmessung der Strukturen vorzugsweise kleiner ist als 500 µm, bevorzugt kleiner 200µm, im Weiteren kleiner 100µm insbesondere kleiner 50 µm. Vorzugsweise wird die erste Paste derart aufgebracht, dass an sich bekannte punkt-, linien- und/oder kammartige Kontaktierungsflächen zwischen Metallisierung und Halbleiter ausgebildet werden.

Ist die Basisdotierung entgegengesetzt zu der Dotierung, die durch die erste Paste erreicht werden kann, ist eine Bedeckung von größer 7%, bevorzugt größer 12 % und insbesondere größer 50 % der Solarzellenseite durch die erste Paste, bzw. die hieraus hervorgehende Struktur, vorteilhaft. Ebenfalls ist in diesem Falle vorteilhaft, wenn mindestens eine Abmessung von Teilbereichen ersten Kontaktstrukturen größer ist als 50 µm, bevorzugt größer als 100µm, im Weiteren größer 200µm, insbesondere größer 500 µm. Diese Teilbereiche werden bevorzugt punktförmig oder linenartig ausgebildet, wobei mindestens eine Abmessung der Strukturen größer ist als 50 µm, bevorzugt größer als 100µm, im Weiteren größer 200µm, insbesondere größer 500 µm.

Als Halbleitersubstrat wird vorzugsweise in Siliziumwafer verwendet, insbesondere mit einer Basisdotierung, die Basiswiderständen im Bereich von 0,1

Ohm cm bis 10 Ohm cm, bevorzugt im Bereich von 1 Ohm cm bis 5 Ohm cm entspricht. Weiterhin ist die Verwendung von Halbleitersubstraten mit einer Dicke kleiner 250 µm, bevorzugt kleiner 170 µm, bevorzugt kleiner 100 µm vorteilhaft.

Weitere vorzugsweise Ausführungsformen und vorteilhafte Merkmale werden im Folgenden anhand der Figuren und der Figurenbeschreibung erläutert. Dabei zeigt:
- Figur 1: ein Teilausschnitt einer Solarzelle, deren rückseitige metallische Kontaktstruktur mittels eines ersten Ausführungsbeispiels des erfindungsgemäßen Verfahrens erzeugt wurde und Lötpads aufweist, welche die Isolierungsschicht nicht durchdringen,
- Figur 2: einen Teilausschnitt einer Solarzelle deren rückseitige metallische Kontaktstruktur mittels eines zweiten Ausführungsbeispiels des erfindungsgemäßen Verfahrens hergestellt wurde, bei der das Lötpad die Isolierungsschicht durchdringt und
- Figur 3: einen Teilausschnitt einer Solarzelle, bei der die rückseitige metallische Kontaktstruktur mittels eines Vergleichsbeispiels ausgebildet wurde, bei dem die gesamte, flächig auf der Rückseite erzeugte Metallschicht als Lötpad ausgebildet ist.

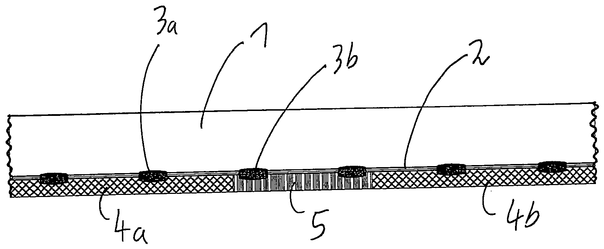

In den Figuren 1 bis 3 ist jeweils ein Teilausschnitt einer aus einem als Siliziumwafer ausgebildeten Halbleitersubstrat 1 hergestellten Solarzelle dargestellt.

Die Solarzelle setzt sich nach rechts und links fort. Insbesondere weist die Solarzelle eine Vielzahl von lokalen elektrischen Kontaktierungsbereichen auf, wobei zur besseren Übersichtlichkeit in den Figuren 1 bis 3 lediglich einige Bereiche dargestellt sind. Weiterhin wurden die Strukturen und Dotierungen an der Vorderseite der dargestellten Solarzelle nicht dargestellt, hier sind in den Figuren 1 bis 3 übliche Solarzellenstrukturen, insbesondere übliche Anordnungen von Emitter und den Emitter kontaktierende metallische Emitterkontaktstrukturen sowie Passivierungsschichten und den Lichteinfall optimierende Texturen und Antireflexionsschichten denkbar.

Gleiche Bezugszeichen bezeichnen in den Figuren 1 bis 3 gleiche Elemente. Das Halbleitersubstrat 1 ist ein p-dotierter Siliziumwafer mit einer Basisdotierung von etwa 2,7 Ohm cm.

Die in Figur 1 dargestellte metallische Kontaktstruktur wurde mittels eines ersten Ausführungsbeispiels des erfindungsgemäßen Verfahrens folgende Verfahrensschritte umfassend erzeugt:
In einem Verfahrensschritt A wurde eine Siliziumdioxidschicht 2 mit einer Dicke von 250 nm aufgebracht und in weiteren Prozessschritten auf eine Dicke von 100 nm rückgeätzt. Für die Oxidation wurden folgende Parameter verwendet:
   thermische Oxidation bei 900°C für 150 min in Wasserdampfatmosphäre (Partialdruck ca. 90-100 %).

Anschließend wurde in einem Verfahrenschritt B1 eine Vielzahl lokaler Bereiche einer Metallpartikel enthaltenden ersten Paste aufgebracht, wobei in Figur 1 zwei Bereiche 3a und 3b exemplarisch gekennzeichnet sind.

Der lokale Bereich 3a gehört hierbei zu einer ersten Gruppe lokaler Bereiche und der lokale Bereich 3b zu einer zweiten Gruppe lokaler Bereiche. Die erste Paste wurde an den lokalen Bereichen 3a, 3b auf die Isolierungsschicht aufgebracht. Anschließend wurde in einem Verfahrensschritt B2 eine zweite Paste in den Bereichen 4a und 4b aufgebracht, derart, dass die zweite Paste die erste Gruppe die mit der ersten Paste 3a bedeckten Bereiche der ersten Gruppe sowie die dazwischen liegenden Bereiche überdeckt.

Weiterhin wurde in einem Verfahrensschritt Ba eine dritte Metallpartikel enthaltende Paste in einem Bereich 5 aufgebracht, so dass zweite und dritte Paste aneinander grenzen und eine elektrische Verbindung aufweisen. Die Pasten können für eine bessere elektrische und mechanische Verbindung auch überlappen.

In einem gemeinsamen Temperaturschritt in einem Verfahrensschritt B3 erfolgte ein globales Erhitzen in einem Temperaturschritt. Der Temperaturschritt wurde in einem Durchlaufofen mit folgenden Parametern ausgeführt: Aufheizen innerhalb von 10 s auf 500°C, Halten dieser Temperatur für 10 s. Weiteres Aufheizen auf 800 °C innerhalb von 5 s, Abkühlen auf Raumtemperatur innerhalb von 15-25 s.

In diesem Temperaturschritt erfolgte einerseits eine Ausbildung von metallischen Strukturen aus erster, zweiter und dritter Paste, wobei lediglich die erste Paste die Isolierungsschicht 2 durchdringend ausgebildet ist. Dies wurde dadurch erreicht, dass die erste Paste Bleiglasfritte in einer Konzentration zwischen 1% und 5% enthält, wohingegen die zweite und die dritte Paste keine Glasfritte enthalten. Ebenso ist die Verwendung einer zweiten und dritten Paste möglich, die für eine Durchdringung eine ungenügende Konzentration oder ungeeignete Art an Glasfritte enthalten.

Im Ergebnis besteht nach Durchführung des Verfahrensschritts B3, wie in Figur 1 dargestellt, somit eine direkte elektrisch leitende Verbindung zwischen erster Paste, bzw. der hieraus resultierenden metallischen Struktur in den lokalen Bereichen 3a, 3b, wohingegen zweite und dritte Paste bzw. die hieraus resultierenden metallischen Strukturen lediglich mittelbar über die erste Paste bzw. die daraus resultierende Metallstruktur mit dem Halbleitersubstrat elektrisch leitend verbunden sind. In diesem Ausführungsbeispiel wurden somit auch unter den Bereichen in denen die Dritte Paste angeordnet ist, lokale Strukturen der ersten Paste angeordnet.

Die dritte Paste weist einen Silberanteil von etwa 90% auf, so dass eine gute Lötbarkeit gegeben ist und die dritte Paste bzw. die hieraus resultierende metallische Struktur somit als Lötpad fungiert.

In einem zweiten Ausführungsbeispiel des erfindungsgemäßen Verfahrens ist die dritte Paste derart ausgebildet, dass sie in dem in Verfahrensschritt B3 durchgeführten Temperaturschritt ebenfalls die Isolierungsschicht 2 durchdringt. Daher ist es in diesem Ausführungsbeispiel nicht notwendig, lokale Bereiche in dem Bereich 5, in dem die dritte Paste aufgebracht wird, mit der ersten Paste zu bedrucken. Die übrigen Verfahrensschritte sind identisch zu den bei Figur 1 beschriebenen Verfahrensschritten.

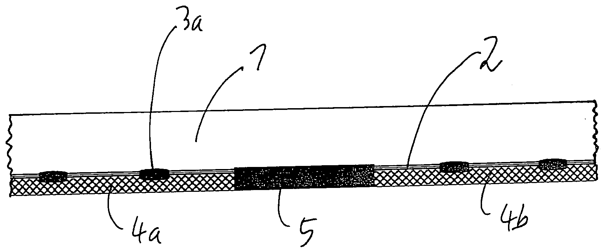

Wie in Figur 2 dargestellt, ergibt sich somit in diesem Ausführungsbeispiel das Ergebnis, dass das mittels der dritten Paste im Bereich 5 ausgebildete Lötpad vollflächig und unmittelbar elektrisch leitend mit dem Halbleitersubstrat 1 verbunden ist, wohingegen die zweite Paste bzw. die hieraus resultierende Metallstruktur lediglich mittelbar über die erste Paste bzw. die hieraus resultierende Metallstruktur mit dem Halbleitersubstrat elektrisch leitend verbunden ist.

In diesem Ausführungsbeispiel werden somit einige Bereiche, in denen die erste Paste gedruckt werden muss, gegenüber dem Ausführungsbeispiel gemäß Figur 1 eingespart, so dass eine Einsparung von Paste und ein besserer elektrischer Kontakt zwischen Lötpad und Halbleitersubstrat erzielt wird.

Die dritte Paste weist im Gegensatz zu dem ersten Ausführungsbeispiel folgende Parameter auf: Sie enthält Glasfritte (Bismut-/Bleiglasfritte), um ein Durchfeuern der Isolationsschicht zu ermöglichen. Weiterhin enthält die dritte Paste Dotierstoff des Basisdotierungstyps, um einen besseren Kontakt und geringere Rekombinationsrate zu erzielen.

In einem Vergleichsbeispiel werden lediglich eine erste und eine zweite Paste verwendet. Die zweite Paste wird hierbei vollflächig auf die Isolierungsschicht bzw. die zuvor aufgebrachte erste Paste aufgebracht. Die Prozessparameter entsprechen den im ersten Ausführungsbeispiel beschriebenen.

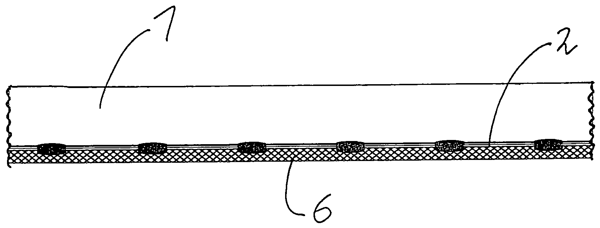

Das Ergebnis ist in Figur 3 dargestellt: Die zweite Paste 6, bzw. die hieraus resultierende metallische Struktur bedeckt vollflächig die Rückseite der herzustellende Solarzelle, wobei lediglich in den lokalen Bereichen, in denen die erste Paste gedruckt wurde, ein elektrisch leitender Kontakt mit dem Halbleitersubstrat 1 besteht.

In diesem Beispiel müssen somit lediglich zwei Pasten gedruckt werden, so dass eine weitere Vereinfachung des Herstellungsprozesses erzielt wird.

Für eine gute Lötbarkeit weist die zweite Paste hierbei einen Silberanteil von 90% auf.

Alle vorgenannten Prozentangaben hinsichtlich der Inhaltsstoffe der Pasten beziehen sich auf Massenprozent.

## Patentansprüche

1. Verfahren zur Herstellung einer metallischen Kontaktstruktur einer photovoltaischen Solarzelle,
folgende Verfahrensschritte umfassend:
A Aufbringen einer elektrisch nichtleitenden Isolierungsschicht (2) auf eine Oberfläche eines Halbleitersubstrates, gegebenenfalls auf eine oder mehrere diese Oberfläche bedeckende Zwischenschichten,
B Aufbringen einer metallischen Kontaktschicht auf die Isolierungsschicht (2), gegebenenfalls auf eine oder mehrere die Isolierungsschicht (2) bedeckende Zwischenschichten und
Erzeugen einer oder mehrerer lokaler elektrisch leitender Verbindung zwischen Halbleitersubstrat (1) und Kontaktschicht durch die Isolierungsschicht (2) und gegebenenfalls weitere Zwischenschichten hindurch,
wobei in Verfahrenschritt B die metallische Kontaktschicht folgende Verfahrensschritte umfassend ausgebildet wird:
B1 eine erste Metallpartikel enthaltende Paste wird an mehreren lokalen Bereichen aufgebracht,
B2 eine zweite Metallpartikel enthaltende Paste wird flächig, zumindest die mit der ersten Paste bedeckten Bereiche sowie die dazwischen liegenden Bereiche zumindest teilweise bedeckend, aufgebracht, und
B3 globales Erhitzen des Halbleitersubstrates und zumindest der ersten und der zweiten Paste in einem Temperaturschritt,
wobei erste und zweite Paste (4a, 4b) sowie der oder weitere auf Verfahrenschritt B1 folgenden Temperaturschritte derart ausgebildet sind, dass die erste Paste (3a, 3b) die Isolierungsschicht (2) durchdringt und einen elektrisch leitenden Kontakt unmittelbar mit dem Halbleitersubstrat (1) bildet, wohingegen die zweite Paste (4a, 4b) die Isolierungsschicht (2) nicht durchdringt und lediglich mittelbar über die erste Paste (3a, 3b) mit dem Halbleitersubstrat (1) elektrisch leitend verbunden ist,
**dadurch gekennzeichnet,**
**dass** Verfahrensschritt B zusätzlich einen Verfahrensschritt Ba umfasst, wobei in Verfahrensschritt Ba auf mindestens einem lokalen Teilbereich eine dritte Metallpartikel enthaltende Paste aufgebracht wird, welche derart ausgebildet ist, dass die dritte Paste nach Wärmeeinwirkung eine lötbare metallische Struktur bildet,
wobei zweite und dritte Paste aneinander angrenzen und eine elektrisch leitende Verbindung ausbilden und
wobei die Kontaktstruktur an einer Rückseite der Solarzelle ausgebildet wird.

2. Verfahren nach Anspruch 1,
**dadurch gekennzeichnet,**
**dass** die dritte Paste sowie der oder die auf Verfahrenschritt B1 folgenden Temperaturschritte derart ausgebildet sind, dass die dritte Paste die Isolierungsschicht (2) nicht durchdringt,
**dass** in Verfahrensschritt B1 die erste Paste (3a, 3b) auf mindestens eine erste Gruppe und eine zweite Gruppe lokaler Bereiche aufgebracht wird, in Verfahrensschritt B2 die zweite Paste (4a, 4b) die mit der ersten Paste bedeckten Bereiche der ersten Gruppe sowie die dazwischen liegenden Bereiche bedeckend und in Verfahrensschritt Ba die dritte Paste (5) die mit der ersten Paste bedeckten die Bereiche der zweiten Gruppe sowie die dazwischen liegenden Bereiche bedeckend aufgebracht wird.

3. Verfahren nach Anspruch 1,
**dadurch gekennzeichnet,**
**dass** die dritte Paste (5) sowie der oder die auf Verfahrenschritt B1 folgenden Temperaturschritte derart ausgebildet sind, dass die dritte Paste (5) in dem oder den auf Verfahrensschritt B1 folgenden Temperaturschritten die Isolierungsschicht (2) durchdringt.

4. Verfahren nach einem der Ansprüche 1 bis 4,
**dadurch gekennzeichnet,**
**dass** die erste und die dritte Paste (5) überlappend aufgebracht werden.

5. Verfahren nach einem der Ansprüche 1 bis 5,
**dadurch gekennzeichnet,**
**dass** erste und dritte Paste identisch sind und in einem gemeinsamen Verfahrensschritt aufgebracht werden.

6. Verfahren nach Anspruch 1,
**dadurch gekennzeichnet,**
**dass** die dritte Paste (5) auf die zweite Paste (4a, 4b) aufgebracht wird.

7. Verfahren nach einem der vorangegangenen Ansprüche,
**dadurch gekennzeichnet,**
**dass** die erste Paste (3a, 3b) einen oder mehrere Stoffe enthält, welche die Isolierungsschicht durchdringen, bevorzugt Glasfritte und
**dass** die zweite Paste (4a, 4b) keine Stoffe enthält, welche die Isolierungsschicht durchdringen, bevorzugt, dass die zweite Paste keine Glasfritte enthält.

8. Verfahren nach einem der vorangegangenen Ansprüche,
**dadurch gekennzeichnet,**
**dass** die Isolierungsschicht (2), als dielektrische Schicht ausgebildet ist, vorzugsweise als Siliziumnitridschicht, Siliziumoxidschicht, Aluminiumoxidschicht, Siliciumcarbidschicht, Titandioxidschicht oder als Schicht enthaltend Mischungen der genannten Materialien.

9. Verfahren nach einem der vorangegangenen Ansprüche,
**dadurch gekennzeichnet,**
**dass** nach Verfahrensschritt B1 und vor Verfahrensschritt B2 die erste Paste (3a, 3b) getrocknet wird, vorzugsweise durch eine Erhitzung auf mindestens 150°C.

10. Verfahren nach einem der vorangegangenen Ansprüche,
**dadurch gekennzeichnet,**
**dass** zwischen Verfahrensschritt B1 und Verfahrensschritt B2 kein Hochtemperaturschritt erfolgt.

11. Verfahren nach einem der vorangegangenen Ansprüche,
**dadurch gekennzeichnet,**
**dass** mindestens eine der Pasten mit Silizium angereichert ist, vorzugsweise in einer Konzentration im Bereich von 0,1 % bis 99 %, bevorzugt im Bereich von 8 % bis 80 %, des Weiteren bevorzugt im Bereich von 12 % bis 60 % und/oder
**dass** die zweite Paste (4a, 4b) und/oder die dritte Paste (5) Silber enthält, vorzugsweise in einer Konzentration im Bereich von 70% bis 100%, bevorzugt im Bereich von 80% bis 100% und/oder
**dass** die erste und/oder dritte Paste (3a, 3b) einen Dotierstoff enthält, vorzugsweise in einer Konzentration im Bereich von 0,1% bis 3%, bevorzugt im Bereich von 0,5% bis 2%.

12. Verfahren nach einem der vorangegangenen Ansprüche,
**dadurch gekennzeichnet,**
**dass** in Verfahrensschritt B3 eine Erwärmung auf mindestens 750°C für eine Zeitdauer von mindestens 3 s erfolgt.

13. Verfahren nach einem der vorangegangenen Ansprüche,
**dadurch gekennzeichnet,**
**dass** mindestens eine der Pasten, vorzugsweise alle Pasten mittels einem der nachfolgenden Verfahren aufgebracht werden: Siebdruckverfahren, Schablonendruckverfahren, Lasertransferdruckverfahrens, Inkjet-Druckverfahren oder Dispensen.

14. Verfahren nach einem der vorangegangenen Ansprüche,
**dadurch gekennzeichnet,**
**dass** die erste Paste einen Dotierstoff des Basisdotierungstyps aufweist und
**dass** die erste Paste derart aufgebracht wird, dass der Bedeckungsanteil der Solarzellenseite durch die erste Paste, bzw. die hieraus hervorgehende Struktur kleiner ist als 50%, besonders vorteilhaft kleiner ist als 12% und bevorzugt kleiner ist als 7% und/oder
**dass** die erste Paste einen Dotierstoff des Emitterdotierungstyps aufweist und
**dass** die erste Paste derart aufgebracht wird, dass der Bedeckungsanteil der Solarzellenseite durch die erste Paste, bzw. die hieraus hervorgehende Struktur größer 7%, bevorzugt größer 12 % und insbesondere größer 50 % ist.

## Claims

1. Process for the production of a metal contact structure of a photovoltaic solar cell,
comprising the following process steps:
A application of an electrically non-conducting insulation layer (2) to a surface of a semiconductor substrate, where appropriate to one or more intermediate layers covering that surface,
B application of a metal contact layer to the insulation layer (2), where appropriate to one or more intermediate layers covering the insulation layer (2), and
creation of one or more local electrically conducting connection(s) between the semiconductor substrate (1) and the contact layer through the insulation layer (2) and where appropriate further intermediate layers,
wherein in process step B the metal contact layer is formed, comprising the following process steps:
B1 a first paste containing metal particles is applied to a plurality of local regions,
B2 a second paste containing metal particles is applied over the surface so as to cover at least some of at least the regions covered with the first paste and the regions located therebetween, and
B3 global heating of the semiconductor substrate and at least the first and the second paste in a temperature step,
wherein the first and second pastes (4a, 4b) and the temperature step or further temperature steps following process step B1 are such that the first paste (3a, 3b) penetrates through the insulation layer (2) and forms an electrically conducting contact directly with the semiconductor substrate (1), whereas the second paste (4a, 4b) does not penetrate through the insulation layer (2) and is in electrically conducting connection with the semiconductor substrate (1) solely indirectly by way of the first paste (3a, 3b),
**characterised in that**
process step B additionally comprises a process step Ba, wherein in process step Ba a third paste containing metal particles is applied to at least a local sub-region, which paste is such that, after being acted upon by heat, the third paste forms a solderable metal structure,
wherein the second and third pastes adjoin one another and form an electrically conducting connection and
wherein the contact structure is formed on a rear side of the solar cell.

2. Process according to claim 1,
**characterised in that**
the third paste and the temperature step(s) following process step B1 are such that the third paste does not penetrate through the insulation layer (2),
in process step B1 the first paste (3a, 3b) is applied to at least a first group and a second group of local regions, in process step B2 the second paste (4a, 4b) is applied so as to cover the regions of the first group that are covered with the first paste and also the regions located therebetween and in process step Ba the third paste (5) is applied so as to cover the regions of the second group covered with the first paste and also the regions located therebetween.

3. Process according to claim 1,
**characterised in that**
the third paste (5) and the temperature step(s) following process step B1 are such that the third paste (5) penetrates through the insulation layer (2) in the temperature step(s) following process step B1.

4. Process according to any one of claims 1 to 4,
**characterised in that**
the first paste and the third paste (5) are applied so as to overlap.

5. Process according to any one of claims 1 to 5,
**characterised in that**
the first and third pastes are identical and are applied in a common process step.

6. Process according to claim 1,
**characterised in that**
the third paste (5) is applied to the second paste (4a, 4b).

7. Process according to any one of the preceding claims,
**characterised in that**
the first paste (3a, 3b) contains one or more substances that penetrate through the insulation layer, preferably glass frit, and the second paste (4a, 4b) does not contain substances that penetrate through the insulation layer,
preferably the second paste does not contain glass frit.

8. Process according to any one of the preceding claims,
**characterised in that**
the insulation layer (2) is in the form of a dielectric layer, preferably in the form of a silicon nitride layer, silicon oxide layer, aluminium oxide layer, silicon carbide layer, titanium dioxide layer or in the form of a layer containing mixtures of the said materials.

9. Process according to any one of the preceding claims,
**characterised in that**
after process step B1 and before process step B2 the first paste (3a, 3b) is dried, preferably by heating to at least 150°C.

10. Process according to any one of the preceding claims,
**characterised in that**
there is no high temperature step between process step B1 and process step B2.

11. Process according to any one of the preceding claims,
**characterised in that**
at least one of the pastes is enriched with silicon, preferably in a concentration in the range of from 0.1 % to 99 %, preferably in the range of from 8 % to 80 %, more preferably in the range of from 12 % to 60 %, and/or
the second paste (4a, 4b) and/or the third paste (5) contain(s) silver, preferably in a concentration in the range of from 70 % to 100%, preferably in the range of from 80 % to 100 %, and/or
the first and/or third paste(s) (3a, 3b) contain(s) a dopant, preferably in a concentration in the range of from 0.1 % to 3 %, preferably in the range of from 0.5 % to 2 %.

12. Process according to any one of the preceding claims,
**characterised in that**
in process step B3 heating to at least 750°C is effected for a period of at least 3 s.

13. Process according to any one of the preceding claims,
**characterised in that**
at least one of the pastes, preferably all the pastes, are applied by means of one of the following methods: screen printing methods, stencil printing methods, laser transfer printing methods, inkjet printing methods or dispensing.

14. Process according to any one of the preceding claims,
**characterised in that**
the first paste has a dopant of the base doping type, and
the first paste is applied in such a way that the proportion of the side of the solar cell covered by the first paste, or the structure resulting therefrom, is less than 50 %, especially advantageously less than 12 % and preferably less than 7 %, and/or
the first paste has a dopant of the emitter doping type, and
the first paste is applied in such a way that the proportion of the side of the solar cell covered by the first paste, or the structure resulting therefrom, is greater than 7%, preferably greater than 12 % and especially greater than 50 %.

## Revendications

1. Procédé de fabrication d'une structure de contact métallique d'une cellule solaire photovoltaïque,
comprenant les étapes suivantes :
A application d'une couche d'isolation (2) électriquement non conductrice sur une surface d'un substrat semi-conducteur, le cas échéant sur une ou plusieurs couches intermédiaires recouvrant cette surface,
B application d'une couche de contact métallique sur la couche d'isolation (2), le cas échéant sur une ou plusieurs couches intermédiaires recouvrant la couche d'isolation (2), et
production d'une ou plusieurs liaisons locales électriquement conductrices entre le substrat semi-conducteur (1) et la couche de contact à travers la couche d'isolation (2) et le cas échéant les autres couches intermédiaires,
la couche de contact métallique étant formée à l'étape de procédé B selon les étapes de procédé suivantes :
B1 une première pâte contenant des particules métalliques est appliquée sur plusieurs zones locales,
B2 une deuxième pâte contenant des particules métalliques est appliquée en nappe recouvrant au moins partiellement au moins les zones couvertes par la première pâte ainsi que les zones intermédiaires, et
B3 le substrat semi-conducteur et au moins la première et la deuxième pâte sont chauffés lors d'une étape thermique,
la première et la deuxième pâte (4a, 4b) ainsi que l'étape thermique ou les étapes thermiques qui suivent l'étape de procédé B1 étant conçues de telle sorte que la première pâte (3a, 3b) traverse la couche d'isolation (2) et forme un contact électriquement conducteur directement avec le substrat semi-conducteur (1), tandis que la deuxième pâte (4a, 4b) ne traverse pas la couche d'isolation (2) et est électriquement reliée au substrat semi-conducteur (1) seulement indirectement par l'intermédiaire de la première pâte (3a, 3b),
**caractérisé en ce**
**que** l'étape de procédé B comprend en outre une étape de procédé Ba, dans laquelle étape de procédé Ba une troisième pâte contenant des particules métalliques est appliquée sur au moins une zone partielle locale, laquelle est conçue de telle sorte que la troisième pâte forme, après action de la chaleur, une structure métallique brasable,
la deuxième et la troisième pâte étant contiguës et formant une liaison électriquement conductrice et
la structure de contact étant formée sur une face arrière de la cellule solaire.

2. Procédé selon la revendication 1,
**caractérisé en ce**
**que** la troisième pâte ainsi que la ou les étapes thermiques qui suivent l'étape de procédé B1 sont conçues de telle sorte que la troisième pâte ne traverse pas la couche d'isolation (2),
**qu'**à l'étape de procédé B1 la première pâte (3a, 3b) est appliquée sur au moins un premier groupe et un deuxième groupe de zones locales, à l'étape de procédé B2 la deuxième pâte (4a, 4b) est appliquée de façon à recouvrir les zones du premier groupe recouvertes par la première pâte ainsi que les zones situées entre elles et, à l'étape de procédé Ba, la troisième pâte (5) est appliquée de façon à recouvrir les zones du deuxième groupe recouvertes par la première pâte ainsi que les zones situées entre elles.

3. Procédé selon la revendication 1,
**caractérisé en ce**
**que** la troisième pâte (5) ainsi que la ou les étapes thermiques qui suivent l'étape de procédé B1 sont conçues de telle sorte que la troisième pâte (5) traverse la couche d'isolation (2) dans la ou les étapes thermiques qui suivent l'étape de procédé B1.

4. Procédé selon l'une des revendications 1 à 4,
**caractérisé en ce**
**que** la première et la troisième pâte (5) sont appliquées en chevauchement.

5. Procédé selon l'une des revendications 1 à 5,
**caractérisé en ce**
**que** la première et la troisième pâte sont identiques et appliquées dans une étape de procédé commune.

6. Procédé selon la revendication 1,
**caractérisé en ce**
**que** la troisième pâte (5) est appliquée sur la deuxième pâte (4a, 4b).

7. Procédé selon l'une des revendications précédentes,
**caractérisé en ce**
**que** la première pâte (3a, 3b) contient une ou plusieurs substances qui traversent la couche d'isolation, de préférence une fritte de verre et
**que** la deuxième pâte (4a, 4b) ne contient pas de substances qui traversent la couche d'isolation, de préférence que la deuxième pâte ne contient pas de fritte de verre.

8. Procédé selon l'une des revendications précédentes,
**caractérisé en ce**
**que** la couche d'isolation (2) est conçue comme une couche diélectrique, de préférence comme une couche de nitrure de silicium, une couche d'oxyde de silicium, une couche d'oxyde d'aluminium, une couche de carbure de silicium, une couche de dioxyde de titane ou une couche contenant des mélanges des matériaux mentionnés.

9. Procédé selon l'une des revendications précédentes,
**caractérisé en ce**
**qu'**après l'étape de procédé B1 et avant l'étape de procédé B2, la première pâte (3a, 3b) est séchée, de préférence par un chauffage à au moins 150 °C.

10. Procédé selon l'une des revendications précédentes,
**caractérisé en ce qu'**aucune étape à haute température n'a lieu entre l'étape de procédé B1 et l'étape de procédé B2.

11. Procédé selon l'une des revendications précédentes,
**caractérisé en ce**
**qu'**au moins une des pâtes est enrichie au silicium, de préférence dans une concentration dans la plage de 0,1 % à 99 %, de préférence dans la plage de 8 % à 80 %, davantage de préférence dans la plage de 12 % à 60 % et/ou que la deuxième pâte (4a, 4b) et/ou la troisième pâte (5) contient de l'argent, de préférence dans une concentration dans la plage de 70 % à 100 %, de préférence dans la plage de 80 % à 100 % et/ou
**que** la première et/ou la troisième pâte (3a, 3b) contient une substance de dopage, de préférence dans une concentration dans la plage de 0,1 % à 3 %, de préférence dans la plage de 0,5 % à 2 %.

12. Procédé selon l'une des revendications précédentes,
**caractérisé en ce**
**qu'**à l'étape de procédé B3, un chauffage à au moins 750 °C pendant une durée d'au moins 3 s est effectué.

13. Procédé selon l'une des revendications précédentes,
**caractérisé en ce**
**qu'**au moins une des pâtes, de préférence toutes les pâtes sont appliquées au moyen d'un des procédés suivants : procédé de sérigraphie, procédé d'impression au stencil, procédé d'impression par transfert laser, procédé d'impression par jet d'encre ou dispensing.

14. Procédé selon l'une des revendications précédentes, **caractérisé en ce que** la première pâte présente une substance de dopage du type dopage de base et que la première pâte est appliquée de telle façon que la proportion de recouvrement du côté cellule solaire par la première pâte, respectivement la structure qui en résulte, est inférieure à 50 %, de manière particulièrement avantageuse inférieure à 12 % et de préférence inférieure à 7 % et/ou que la première pâte présente une substance de dopage du type dopage d'émetteur et
que la première pâte est appliquée de telle façon que la proportion de recouvrement du côté cellule solaire par la première pâte, respectivement la structure qui en résulte, est supérieure à 7 %, de préférence supérieure à 12 % et en particulier supérieure à 50 %.
